# EUROPEAN PATENT APPLICATION

(11) **EP 2 293 659 A2**
(43) Date of publication of application: **09.03.2011**
(21) Application number: 10173477.0
(22) Date of filing: 19.08.2010
(51) Int. Cl.: H05K 7/20

(54) **Data Center, Cooling System, and Method of Cooling Information Technology Device**

(30) Priority: 04.09.2009 JP 2009205327
(71) Applicant: FUJITSU LIMITED, Kawasaki-shi, Kanagawa 211-8588 (JP)
(72) Inventor: Katsui, Tadashi, Kawasaki-shi Kanagawa 211-8588 (JP); Ishimine, Junichi, Kawasaki-shi Kanagawa 211-8588 (JP); Saito, Seiichi, Kawasaki-shi Kanagawa 211-8588 (JP); Suzuki, Masahiro, Kawasaki-shi Kanagawa 211-8588 (JP); Nagamatsu, Ikuro, Kawasaki-shi Kanagawa 211-8588 (JP); Ohba, Yuji, Kawasaki-shi Kanagawa 211-8588 (JP); Yamaoka, Nobuyoshi, Kawasaki-shi Kanagawa 211-8588 (JP); Ueda, Akira, Kawasaki-shi Kanagawa 211-8588 (JP); Uraki, Yasushi, Kawasaki-shi Kanagawa 211-8588 (JP)
(74) Representative: Wilding, Frances Ward

(57) **Abstract**

A data center includes a housing room (2) that nouses an information technology device (10a); an air conditioning machine (11) that cools air in the housing room (2) and supplies the air under a floor of the housing room (2); a grille (7) that allows the air supplied under the floor to circulate in the housing room (2); and a rack device (10) that houses the information technology device (10a). In the housing room (2) in the data center, the rack device (10) is arranged in such a way as to surround the grille (7). The information technology device (10a) is housed in the rack device (10) in such a way as to take in air from a space (20) surrounded by the rack device (10) via the grille (7) and discharge air to the housing room (2). The air conditioning machine (11) is arranged at a side from which the information technology device (10a) discharges air.

## Description

### FIELD

The embodiments discussed herein are directed to a data center, a cooling system, and a method of cooling an information technology device.

### BACKGROUND

In a data center where a rack device which mounts information technology (IT) devices such as a computer, a server, and a router is arranged, an air conditioning machine which takes in warm air and supplies cooling air is traditionally used to perform a cooling of IT devices.

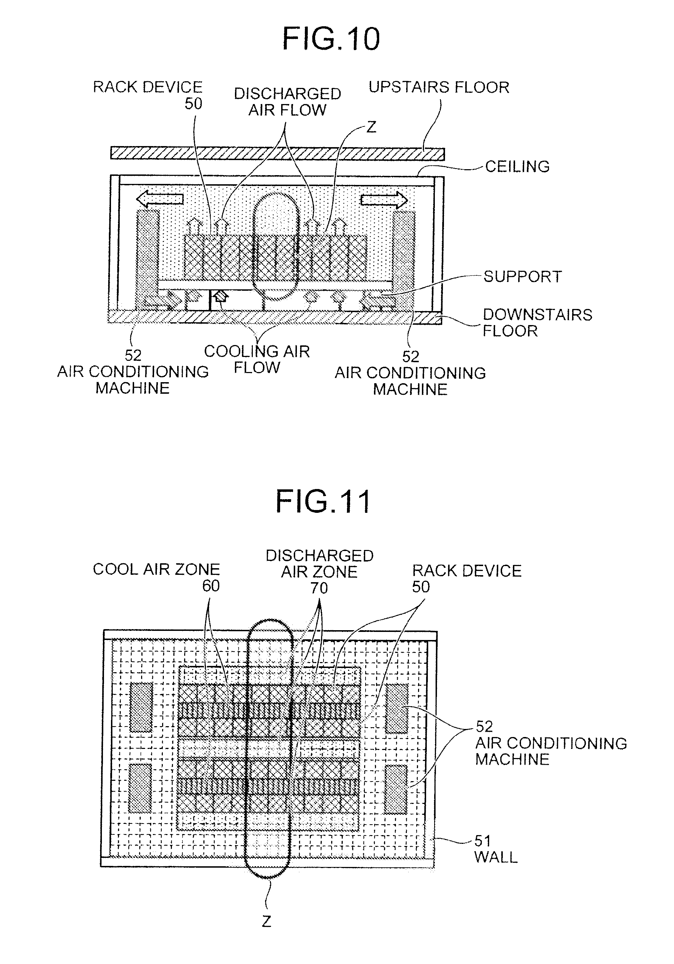

For example as illustrated in FIG. 10, a popularly-used air conditioning machine 52 takes in air discharged from an IT device mounted on a rack device 50 in a data center and supplies, after cooling, cooling air under a floor in the data center. The IT device mounted in the rack device then takes in the cooling air supplied under the floor from its front surface by a fan and the like, makes the air pass through inside the device itself, and cools electronic devices including a central processing unit (CPU) and the like. After that, the IT device discharges air which is warmed due to the cooling of the electronic devices from its back surface. In this manner, cooling air and discharged air circulate depending on the air conditioning machine 52 and the cooling of the IT device in the rack device 50 is performed in the data center. FIG. 10 illustrates an example of a circulation of cooling air and discharged air depending on an air conditioning machine arranged in a conventional data center.

Here, an example of a data center in which the rack device 50 and the air conditioning machine 52 are arranged will be represented. FIG. 11 illustrates a housing room in a data center according to a conventional technique. As illustrated in FIG. 11, a plurality of rack devices 50 are arranged in the data center in such a way that air intake sides of IT devices face each other, in addition to a plurality of air conditioning machines 52. By making a floor at the air intake sides of the IT devices formed by a grille, the IT devices can take in cooling air which is supplied under the floor from the air conditioning machines 52 via the grille. In addition, the IT devices discharge air used for cooling electronic devices mounted in itself from its back surface. Here, a site where the cooling air concentrates is referred to as a cool air zone 60 and a site where the discharged air concentrates is referred to as a discharged air zone 70.

In recent years, higher functionality and performance of IT devices have caused a significant increase in a product electricity and a CPU electricity per unit area, thereby causing an increase in an amount of heat generation per unit area. Therefore, hazardous circumstances such as a system operation of exceeding a standard temperature of IT devices, an extreme temperature distribution in a data center, and a heat accumulated area are sometimes caused. In response, as a method for avoiding such hazardous circumstances, a method of arranging a local cooling unit on top of the rack device 50 of which heat generation amount is large and locally supplying cooling air and the like are adopted, for example. More detailed information about the conventional method can be obtained in technical documentations: John Niemann, "Hot-aisle vs. cold-aisle containment", White Paper #135 of American Power Conversion Corp., 2008; and White Paper LjTC040202TB of Hewlett-Packard Development Company, L.P., 2004/02.

However, there have been a problem of having a danger of a water leakage and a problem of a bad cooling efficiency in a data center in the conventional technique described above.

In a case of using a local cooling unit, for example, since a pipe for water and the like is supposed to be arranged near the ceiling at the rack device 50, there is a chance of causing a break with an IT device wet when a water leakage occurs. Besides, for example in a case of additionally providing an IT device of which heat generation amount is large in the rack device 50 housing an IT device of which heat generation amount is not large, the air conditioning machine 52 sometimes operates in conjunction with a temperature of air discharged from the IT device of which heat generation amount is large. In this case, the IT device of which heat generation amount is not large is cooled more than necessary, causing a failure of the IT device contrary to the intention.

Moreover, not cooling air but warm discharged air is taken in in an area denoted by a reference character "Z" in FIGS. 10 and 11, i.e., in the rack device 50 placed at a position away from the air conditioning machine 52 and thereby a heat accumulated area where an electronic device cannot be cooled is caused. As a result, an area (X) of which temperature is high is generated in the data center and thereby a cooling efficiency in the data center deteriorates.

Accordingly, it is considered desirable to provide a data center, a cooling system, and a method of cooling an information technology device which enable a safe cooling of an information technology device and an enhancement of a cooling efficiency in a data center.

### SUMMARY

According to an aspect of an embodiment of the invention, a data center includes a housing room that houses an information technology device; an air conditioning machine that cools air in the housing room and supplies the air under a floor of the housing room; a grille that allows the air supplied under the floor to circulate in the housing room; and a rack device that houses the information technology device. In the data center, the rack device is arranged in such a way as to surround the grille, the information technology device is housed in the rack device in such a way as to take in the air from a space surrounded by the rack device via the grille and discharge air to the housing room, and the air conditioning machine is arranged at a side from which the information technology device discharges air.

According to another aspect of an embodiment of the invention, a data center includes a housing room that houses an information technology device; an air conditioning machine that cools air in the housing room and supplies the air under a floor of the housing room; a grille that allows the air supplied under the floor to circulate in the housing room; and a rack device that houses the information technology device. The rack device is arranged in such a way as to surround the air conditioning machine, the information technology device is housed in the rack device in such a way as to take in the air supplied under the floor via the grille and discharge air to an area surrounded by the rack device, and the air conditioning machine is arranged in the area surrounded by the rack device at a side from which the information technology device discharges air.

According to still another aspect of an embodiment of the invention, a data center includes a housing room that houses an information technology device; an air conditioning machine that cools air in the housing room and supplies the air under a floor of the housing room; a grille that allows the air supplied under the floor to circulate in the housing room; and a rack device that houses the information technology device. The rack device is arranged in such a way as to divide the housing room into a first area and a second area, the grille is arranged in the first area, the information technology device is housed in the rack device in such a way as to take in the air via the grille arranged in the first area and discharge air to the second area, and the air conditioning machine is arranged in the second area.

### BRIEF DESCRIPTION OF DRAWINGS

FIG. 1 is a view, seen from above, of a housing room in a data center according to a first embodiment;
FIG. 2 is a cross-sectional view a section of which is obtained by a cutting along a line A-A' illustrated in FIG. 1;
FIG. 3 is a view, seen from above, of a housing room in a data center according to a second embodiment;
FIG. 4 is a cross-sectional view a section of which is obtained by a cutting along a line B-B' illustrated in FIG. 3;
FIG. 5 is a view, seen from above, of a housing room in a data center according to a third embodiment;
FIG. 6 is a view, seen from above, of a housing room when a rack device 10 is arranged to form a rhombus shape;
FIG. 7 is a view, seen from above, of a housing room when a grille 7 and a rack device 10 are arranged in such a way as to be parallel to either direction of wall 5;
FIG. 8 illustrates an example of arranging a plate under a floor;
FIG. 9 illustrates an example of arranging a plate on a floor;
FIG. 10 illustrates an example of a circulation of cooling air and discharged air depending on an air conditioning machine arranged in a conventional data center; and
FIG. 11 illustrates a housing room in the data center according to the conventional technique.

### DESCRIPTION OF EMBODIMENTS

Preferred embodiments of the present invention will be explained with reference to the accompanying drawings. It should be noted that the present invention is not limited to the embodiments.

### [a] First Embodiment

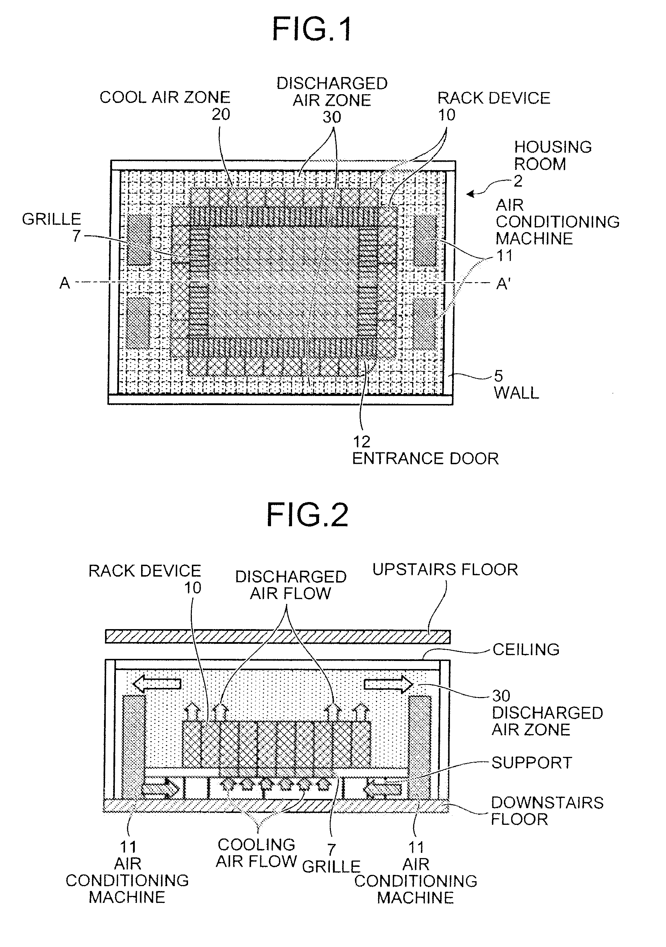

First, a data center to be disclosed as an embodiment will be explained with reference to FIG. 1. FIG. 1 is a view, seen from above, of a housing room in a data center according to a first embodiment.

As illustrated in FIG. 1, a housing room 2 in a data center is isolated from another housing room by being surrounded by a wall 5 and includes therein a grille 7, a rack device 10, an air conditioning machine 11, and an entrance door 12.

The grille 7 is arranged on a floor of the housing room 2 and has ventilation openings which allow air to circulate from a space under the floor to an inside of the housing room. The rack device 10 is a device which houses therein a plurality of information technology (IT) devices 10a and is arranged in such a way as to surround the grille 7 arranged under the floor of the housing room 2. Air under the floor flows into the housing room 2 via the grille 7, i.e., from a site of the grille 7.

The IT device 10a takes in, by a fan and the like, cooling air which is cool air supplied from the air conditioning machine 11 and cools electronic devices such as a central processing unit (CPU) and a large scale integration (LSI) which are provided inside the IT device 10a. The IT device 10a then discharges air which is warmed due to the cooling of the interior electronic devices from its back surface.

In addition, the IT device 10a has a light emitting diode (LED) which indicates a state of an electronic device housed therein and a state of a system provided by the IT device 10a, and gives an alarm by turning on, for example, a red color LED in case of an abnormality. The IT device 10a is housed in the rack device 10 to take in air from a space surrounded by the rack device 10 via the grille 7 and discharge air into the housing room 2.

The air conditioning machine 11 performs cooling by taking in air including the air discharged from the IT device 10a in the housing room 2 and supplies, after the cooling, cooling air under the floor of the housing room 2. The air conditioning machine 11 is arranged at a side from which the IT device 10a discharges air in the housing room 2.

The entrance door 12 is a door used by a maintenance person who performs maintenance in the data center, such as a maintenance of the IT device 10a housed in the rack device 10, an expansion of the IT device 10a, and an expansion of the rack device 10 itself. The entrance door 12 is arranged alongside the rack device 10.

As described above, the rack device 10 surrounds the grille 7, the housed IT device 10a is arranged in such a way that its air intake side faces the side of the grille 7, and the air conditioning machine 11 is arranged in an area where discharged air of the IT device 10a concentrates. This configuration allows the rack device 10 to insulate a cool air zone 20 where cooling air flowing into the housing room 2 from the space under the floor via the grille 7 concentrates and a discharged air zone 30 where discharged air, which is warmed air after being used for cooling the IT device 10a concentrates.

Consequently, the IT device 10a can cool interior electronic devices by taking in cooling air from the cool air zone 20 in which discharged air cannot be contained easily and the air conditioning machine 11 can take in discharged air from the IT device 10a quickly. As a result, an IT device can be safely cooled without a necessity of using a local cooling unit and a cooling efficiency in the data center can be enhanced. In addition, since the air intake side, i.e., a front surface having the LED of the IT device 10a is located at a side of the cool air zone 20, a maintenance person can look over LEDs of all IT devices by entering the cool air zone 20 from the entrance door 12, which leads to a prompt detection of an alarm.

Next, an air flow in the housing room 2 illustrated in FIG. 1 will be explained with reference to FIG. 2. FIG. 2 is a cross-sectional view a section of which is obtained by a cutting along a line A-A' illustrated in FIG. 1. As illustrated in FIG. 2, the cooling air supplied under the floor circulates in the housing room 2 via the grille 7 without mixing with discharged air and is taken in by the IT device 10a housed in the rack device 10. Besides, the air (discharged air) discharged from the IT device 10a is taken in by the air conditioning machine 11 without mixing with the cooling air and flowing under the floor. Therefore, the IT device 10a can take in cooler air and moreover an accumulation of discharged air in the housing room 2 can be prevented. As a result, an occurrence of a heat accumulated area in which discharged air is taken in by the IT device 10a and therefore the IT device 10a cannot be cooled can be prevented as much as possible.

### [b] Second Embodiment

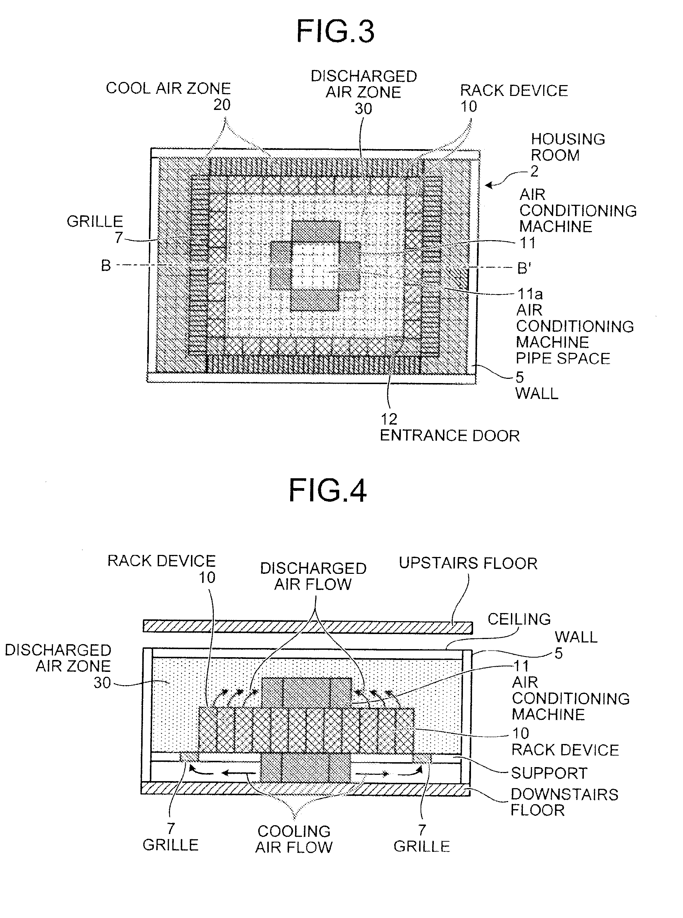

An IT device can be cooled safely in a housing room in a data center to be disclosed in an embodiment of the invention even with an arrangement different from the first embodiment. Then, another example of the data center disclosed in the embodiment of the invention will be explained in a second embodiment with reference to FIGS. 3 and 4. FIG. 3 is a view, seen from above, of a housing room in a data center according to the second embodiment.

As illustrated in FIG. 3, the rack device 10 is arranged in such a way as to surround the air conditioning machine 11, the IT device 10a is housed in the rack device 10 in such a way as to take in air supplied under the floor via the grille 7 and discharge air to an area surrounded by the rack device 10. Besides, the air conditioning machine 11 is arranged in an area surrounded by the rack device 10 and at a side from which the IT device 10a discharges air in such a way as to surround an air conditioning machine pipe space 11a in which a pipe of the air conditioning machine is housed. In other words, a front surface as an air intake side of the IT device 10a faces the side of the grille 7 and a back surface as an air discharge side faces the side of the air conditioning machine 11.

This arrangement allows the rack device 10 to insulate a cool air zone 20 where cooling air flowing into the housing room 2 from the space under the floor via the grille 7 concentrates and a discharged air zone 30 where discharged air, which is warmed air after being used for cooling the IT device 10a concentrates. As a result, an IT device can be safely cooled without a necessity of using a local cooling unit and a cooling efficiency in the data center can be enhanced. In addition, since the discharged air zone according to the second embodiment, compared to the first embodiment, is an area surrounded by the rack device 10 and the air conditioning machine 11 is arranged in the discharged air zone, discharged air is more quickly taken in by the air conditioning machine 11. Therefore, an increase in temperature in the entirety of the data center can be suppressed and a cooling efficiency can be enhanced, compared to the first embodiment.

Next, an air flow in the housing room 2 illustrated in FIG. 3 will be explained with reference to FIG. 4. FIG. 4 is a cross-sectional view a section of which is obtained by a cutting along a line B-B' illustrated in FIG. 3. As illustrated in FIG. 4, cooling air supplied under the floor circulates upward from the floor via the grille 7 at a neighborhood of the wall 5. Therefore, the cooling air is supposed to pass under the floor of the discharged air zone and does not mix with discharged air. In addition, since the air (discharged air) discharged from the IT device 10a is quickly taken in by the air conditioning machine 11, the discharged air does not mix with the cooling air passing through the grille 7. This configuration allows more strongly preventing an occurrence of a heat accumulated area compared to the first embodiment.

### [c] Third Embodiment

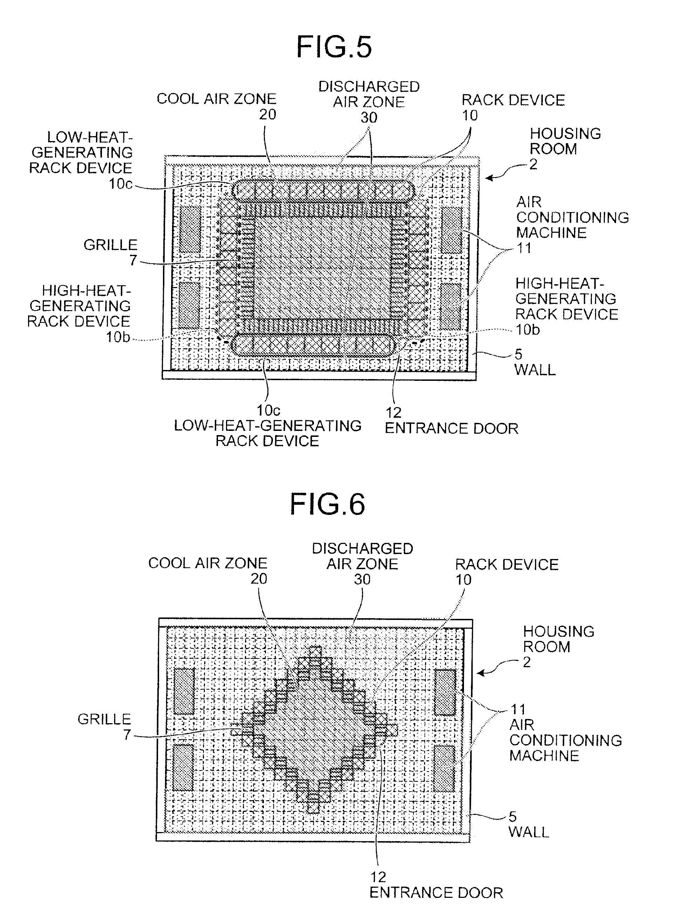

The rack device can be arranged in the housing room in the data center disclosed in the embodiment of the invention so that an IT device can be cooled more efficiently than the first embodiment. Then, still another example of the data center disclosed in the embodiment of the invention will be explained in a third embodiment with reference to FIG. 5. FIG. 5 is a view, seen from above, of a housing room in a data center according to the third embodiment.

As illustrated in FIG. 5, the grille 7, the rack device 10, and the air conditioning machine 11 are arranged in the housing room 2 in the data center according to the third embodiment in the same way as the first embodiment. In other words, the rack device 10 surrounds the grille 7, the housed IT device 10a is arranged in such a way that its air intake side faces the side of the grille 7, and the air conditioning machine 11 is arranged in an area where discharged air of the IT device 10a concentrates. The rack device 10 allows insulation between a cool air zone 20 via the grille 7 and a discharged air zone 30 which is used by the IT device 10a for the cooling.

However, the rack device 10 includes a high-heat-generating rack device 10b which has a plurality of high-performance IT devices 10a and of which heat generation amount is large, and a low-heat-generating rack device 10c which has a plurality of comparatively-low-performance IT devices 10a and of which heat generation amount is small, which is different from the first embodiment. The high-heat-generating rack device 10b discharges air of higher temperature than the low-heat-generating rack device 10c.

In this case, the high-heat-generating rack device 10b is arranged at a place closer to the air conditioning machine 11 as illustrated in FIG. 5. By this arrangement, discharged air of higher temperature when discharged from the high-heat-generating rack device 10b can be taken in quickly by the air conditioning machine 11 without filling the housing room 2. As a result, a cooling efficiency in the data center can further be enhanced and an improvement in temperature in the housing room 2 can be prevented, compared to the case in which the arrangement of the high-heat-generating rack device 10b and the low-heat-generating rack device 10c is not taken into consideration.

### [d] Fourth Embodiment

While the example of arranging the rack device 10 to form a rectangular shape in the first embodiment, the embodiment is not limited thereto. For example, the grille 7 can arranged to form a rhombus shape and the rack device 10 can also be arranged to form a rhombus shape in such a way as to surround the grille 7, as illustrated in FIG. 6. In addition, the shape is not limited to the rhombus and may be any shapes such as a round shape and a polygonal shape as long as the cool air zone 20 and the discharged air zone 30 can be insulated. Moreover, also concerning the arrangement example explained in the second embodiment, any shapes such as a rhombus shape, a round shape, and a polygonal shape may be adopted as long as the cool air zone 20 and the discharged air zone 30 can be insulated as described above. FIG. 6 is a view, seen from above, of a housing room when the rack device 10 is arranged to form a rhombus shape.

### [e] Fifth Embodiment

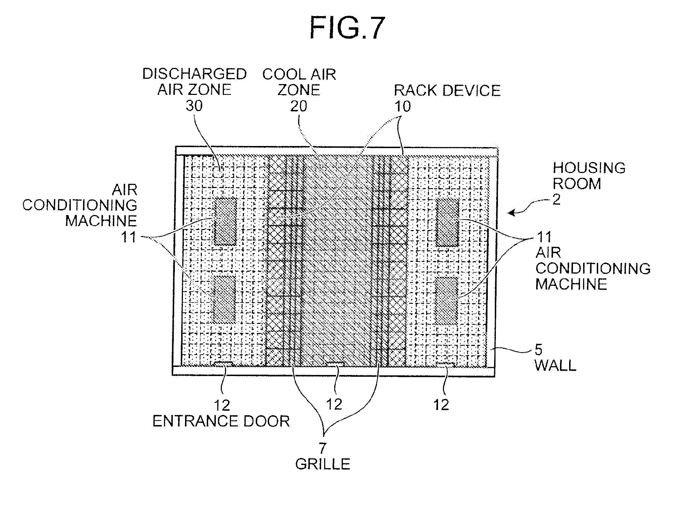

In the housing room in the data center disclosed in the embodiment of the invention, the rack device 10 is not necessarily arranged in such a way as to surround the grille 7. For example, the grille 7 and the rack device 10 can be arranged in such a way as to be parallel to either direction of the wall 5, as illustrated in FIG. 7. This arrangement allows a division into the cool air zone 20 and the discharged air zone 30. FIG. 7 is a view, seen from above, of a housing room when the grille 7 and the rack device 10 are arranged in such a way as to be parallel to either direction of wall 5.

Even in this case, the IT device 10a is housed in the rack device 10 so that its air intake side faces the side of the grille 7 and takes in cooling air from the grille 7. Besides, the air conditioning machine 11 is arranged at a side of the air discharge from the IT device 10a, i.e., in the discharged air zone 30, which is an area opposite to the grille 7 with respect to the rack device 10.

This arrangement allows dividing the area into one cool air zone 20 and two discharged air zones 30. Therefore, an IT device can be safely cooled and a cooling efficiency in a data center can be enhanced similarly to the first to fourth embodiments.

### [f] Sixth Embodiment

Various methods can be adopted for allowing cooling air under the floor to pass easily through the grille 7 in the housing room in the data center disclosed in the embodiments of the invention.

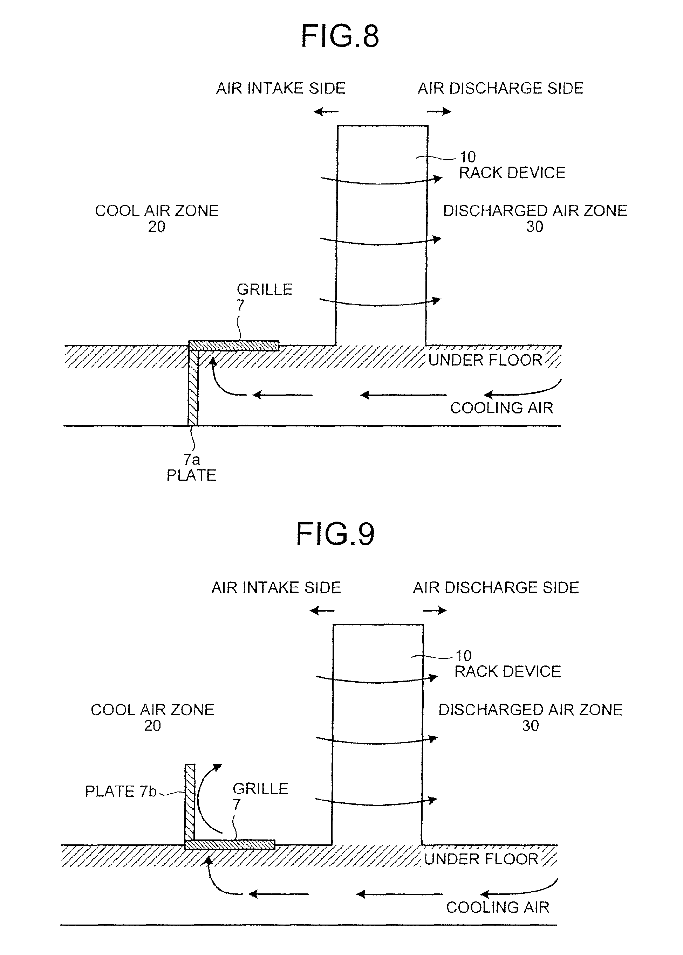

For example, a plate 7a is arranged under the floor where the grille 7 is arranged in such a way as to be perpendicular to a surface of the grille 7 at a side opposite to the rack device 10, as illustrated in FIG. 8. By this arrangement, the cooling air under the floor goes upward by hitting the plate 7a under the grille 7. As a result, all the cooling air supplied under the floor from the air conditioning machine 11 can circulate in the housing room 2 via the grille 7 and be fed efficiently to the cool air zone 20. FIG. 8 illustrates the example of arranging a plate under the floor.

For example, a plate 7b is arranged on the floor where the grille 7 is arranged in such a way as to be perpendicular to a surface of the grille 7 at a side opposite to the rack device 10, as illustrated in FIG. 9. This arrangement allows preventing the cooling air circulating from the space under the floor to the inside of the housing room 2 via the grille 7 from circulating to a direction opposite to the rack device 10, i.e., to a direction away from the rack device 10. In other words, the cooling air circulating in the housing room 2 is made to circulate to a side of the rack device 10, i.e., to a direction to the rack device 10. As a result, the IT device 10a housed in the rack device 10 can take in the cooling air efficiently. As a material of the plates 7a and 7b explained here, any materials such as a veneer plate, an acryl plate, and a concrete partition may be used. FIG. 9 illustrates the example of arranging a plate on the floor.

## Claims

1. A data center, comprising:
a housing room (2) that houses an information technology device (10a);
an air conditioning machine (11) that cools air in the housing room (2) and supplies the air under a floor of the housing room (2);
a grille (7) that allows the air supplied under the floor to circulate in the housing room (2); and
a rack device (10) that houses the information technology device (10a), wherein
the rack device (10) is arranged in such a way as to surround the grille (7),
the information technology device (10a) is housed in the rack device (10) in such a way as to take in the air from a space (20) surrounded by the rack device (10) via the grille (7) and discharge air to the housing room (2), and
the air conditioning machine (11) is arranged at a side from which the information technology device (10a) discharges air.

2. A data center, comprising:
a housing room (2) that houses an information technology device (10a);
an air conditioning machine (11) that cools air in the housing room (2) and supplies the air under a floor of the housing room (2);
a grille (7) that allows the air supplied under the floor to circulate in the housing room (2); and
a rack device (10) that houses the information technology device (10a), wherein
the rack device (10) is arranged in such a way as to surround the air conditioning machine (11),
the information technology device (10a) is housed in the rack device (10) in such a way as to take in the air supplied under the floor via the grille (7) and discharge air to an area (30) surrounded by the rack device, and
the air conditioning machine (11) is arranged in the area (30) surrounded by the rack device (10) at a side from which the information technology device (10a) discharges air.

3. The data center according to claim 1 or 2, wherein the rack device (10) includes
a high-heat-generating rack device (10b) which has a high-performance information technology device (10a) and of which heat generation amount is large and
a low-heat-generating rack device (10c) which has a low-performance information technology device (10a) and of which heat generation amount is small, and
the high-heat-generating rack device (10b) is arranged at a place closer to the air conditioning machine (11) than the low-heat-generating rack device (10c).

4. A data center, comprising:
a housing room (2) that houses an information technology device (10a);
an air conditioning machine (11) that cools air in the housing room (2) and supplies the air under a floor of the housing room (2);
a grille (7) that allows the air supplied under the floor to circulate in the housing room (2); and
a rack device (10) that houses the information technology device (10a), wherein
the rack device (10) is arranged in such a way as to divide the housing room (2) into a first area (20) and a second area (30),
the grille (7) is arranged in the first area (20),
the information technology device (10a) is housed in the rack device (10) in such a way as to take in the air via the grille (7) arranged in the first area (20) and discharge air to the second area (30), and
the air conditioning machine (11) is arranged in the second area (30).

5. A cooling system, comprising:
an air conditioning unit (11) that cools air in a housing room (2) housing an information technology device (10a) and supplies the air under a floor of the housing room (2);
a circulation unit (7) that allows the air supplied under the floor to circulate in the housing room (2); and
a device housing unit (10) that houses the information technology device (10a), wherein
the device housing unit (10) is arranged in such a way as to surround the grille (7),
the information technology device (10a) is housed in the device housing unit (10) in such a way as to take in the air from a space (20) surrounded by the device housing unit (10) via the circulation unit (7), cool an interior electronic device, and discharge air after the cooling to the housing room (7), and
the air conditioning unit (11) is arranged at a side from which the information technology device (10a) discharges air.

6. A cooling system, comprising:
an air conditioning unit (11) that cools air in a housing room (2) housing an information technology device (10a) and supplies the air under a floor of the housing room (2);
a circulation unit (7) that allows the air supplied under the floor to circulate in the housing room (2); and
a device housing unit (10) that houses the information technology device (10a), wherein
the device housing unit (10) is arranged in such a way as to surround the air conditioning unit (11),
the information technology device (10a) is housed in the device housing unit (10) in such a way as to take in the air supplied under the floor via a grille (7), cool an interior electronic device, and discharge air after the cooling to an area (30) surrounded by the rack device (10), and
the air conditioning unit (11) is arranged in the area (30) surrounded by the device housing unit (10) at a side from which the information technology device (10a) discharges air.

7. A method of cooling an information technology device (10a), wherein the information technology device (10a) is retained in a rack device (10) that is arranged in such a way as to surround a grille (7) for circulating, in a housing room (2) in which the information technology device (10a) is housed, cooling air supplied by an air conditioning machine (11) under a floor of the housing room (2), the method comprising:
taking in the cooling air via the grille (7) to cool an electronic device contained in the information technology device (10a); and
discharging the cooling air used for cooling the electronic device to the air conditioning machine (11) arranged at an air discharge side of the information technology device (10a).

8. A method of cooling an information technology device (10a), wherein the information technology device (10a) is retained in a rack device (10) that is arranged in such a way as to surround an air conditioning machine (11) for supplying cooling air under a floor of a housing room (2) in which the information technology device (10a) is housed, the method comprising:
taking in cooling air via a grille (7) for circulating in the housing room(2) air supplied under the floor to cool an electronic device contained in the information technology device (10a), the grille (7) being arranged in such a way as to surround the rack device (10); and
discharging the cooling air used for cooling the electronic device to the air conditioning machine (11) arranged in an area surrounded by the rack device (10) at an air discharge side of the information technology device (10a).
